(19) Europäisches Patentamt
European Patent Office
Office européen des brevets

(11) **EP 3 621 124 B1**

(12) **FASCICULE DE BREVET EUROPEEN**

(45) Date de publication et mention
de la délivrance du brevet:
**27.12.2023 Bulletin 2023/52**

(21) Numéro de dépôt: **19196056.6**

(22) Date de dépôt: **06.09.2019**

(51) Classification Internationale des Brevets (IPC):
*H10K 30/83* (2023.01)   *H01L 31/0216* (2014.01)
*H01L 31/0224* (2006.01)   *H01L 31/0392* (2006.01)
*H01L 31/0747* (2012.01)   *H01L 31/18* (2006.01)
*B05D 1/18* (2006.01)

(52) Classification Coopérative des Brevets (CPC):
**H01L 31/02167; H01L 31/022425;
H01L 31/022466; H01L 31/03921; H01L 31/0747;
H01L 31/1884; H10K 30/83;** B05D 1/185;
Y02E 10/549; Y02P 70/50

(54) **STRUCTURE MULTICOUCHE NOTAMMENT POUR CELLULES PHOTOVOLTAÏQUES, INTEGRANT UNE MONOCOUCHE MOLECULAIRE AUTOASSEMBLEE, SAM**

MEHRSCHICHTENSTRUKTUR, INSBESONDERE FÜR FOTOVOLTAIKZELLEN, DIE EINE SELBST AGGREGIERENDE MOLEKULARE MONOLAGE (SAM) UMFASST

MULTILAYER STRUCTURE, IN PARTICULAR FOR PHOTOVOLTAIC CELLS, INCLUDING A SELF-ASSEMBLED MOLECULAR SINGLE-LAYER, SAM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.09.2018 FR 1858052**

(43) Date de publication de la demande:
**11.03.2020 Bulletin 2020/11**

(73) Titulaire: **Commissariat à l'Energie Atomique et aux Energies Alternatives
75015 Paris (FR)**

(72) Inventeurs:
• **CELLE, Caroline
38054 GRENOBLE CEDEX 09 (FR)**
• **MANCEAU, Matthieu
38054 GRENOBLE CEDEX 09 (FR)**

(74) Mandataire: **Cabinet Nony
11 rue Saint-Georges
75009 Paris (FR)**

(56) Documents cités:
**US-A1- 2012 111 401    US-A1- 2015 171 241**

• **YIP HIN-LAP ET AL: "Self-assembled monolayer modified ZnO/metal bilayer cathodes for polymer/fullerene bulk-heterojunction solar cells", APPLIED PHYSICS LETTERS, A I P PUBLISHING LLC, US, vol. 92, no. 19, 16 mai 2008 (2008-05-16), pages 193313-193313, XP012106937, ISSN: 0003-6951, DOI: 10.1063/1.2919524**

**Description**

La présente invention concerne une structure multicouche convenant tout particulièrement aux cellules photovoltaïques et notamment aux cellules à base de silicium comme notamment de type hétérojonction connue sous l'acronyme HET, aux cellules comportant des matériaux pérovskites ou encore les cellules tandems comprenant du silicium et un ou des matériaux pérovskites. De telles structures multicouches sont connues dans l'état de la technique, par exemple dans les documents US 2015/171241 A1, US 2012/111401 A1 et "Self-assembled monolayer modified ZnO/metal bilayer cathodes for polymer/fullerene bulk-heterojunction solar cells" ; Yip Hip-Lap et al. ;Appl. Physics Letters, vol.92, no.19, 16.05.2008, p.193313-193313, ISSN: 0003-6951, DOI 10.1063/1.2919524.

Plus précisément, la présente invention se rapporte à l'étape de métallisation intervenant lors de la fabrication de ces cellules et au cours de laquelle est réalisé le dépôt d'un matériau conducteur métallique sur une couche d'oxyde transparent conducteur, typiquement une couche d'oxyde d'indium dopé à l'étain, dit encore ITO. Ce dépôt de matériau conducteur métallique, classiquement réalisé sous la forme d'un dépôt continu ou d'un réseau de fils, sur une couche d'oxyde transparent conducteur (TCO) constitue les contacts électriques au sein de dispositifs électroniques, par exemple des dispositifs photovoltaïques.

Lorsqu'il est réalisé un dépôt à l'état de fils, en face avant des cellules, il convient de déposer une quantité de matière suffisante pour garantir une faible résistance de ligne et donc une collecte du courant optimale mais également de limiter la largeur de ces lignes, dites encore fils, pour prévenir des pertes de rendement par ombrage au niveau du dispositif.

Si ce compromis est aujourd'hui très bien maîtrisé, dans le cas d'un procédé par sérigraphie, il n'en est malheureusement pas de même pour le procédé jet d'encre.

Compte-tenu des propriétés physico-chimiques des encres, notamment de très faible viscosité, et des spécificités de ce mode de dépôt, le plus souvent par projection de gouttes à des vitesses de plusieurs mètres par seconde, les propriétés du matériau support et notamment son énergie de surface jouent un rôle prépondérant dans l'étalement de l'encre qui est généralement difficile à maîtriser (e.g. largeurs importantes et comportements dispersés pour des substrats a priori identiques).

Or, le procédé jet d'encre est particulièrement intéressant en raison à la fois de l'absence de contrainte mécanique (technique dite « sans contact ») et de la réduction des contraintes thermiques qu'il offre en comparaison de la sérigraphie. En effet, du fait de l'utilisation d'encres constituées d'objets de dimensions nanométriques (contrairement à la sérigraphie où les particules sont micrométriques) les traitements thermiques nécessaires à l'obtention de résistivités faibles sont nettement réduits. Ceci est donc tout particulièrement intéressant à l'égard des dispositifs qui ne présentent pas une stabilité thermique très élevée comme par exemple les cellules à base de matériaux de type pérovskite.

Malheureusement, il est difficile, du fait des propriétés respectives de la majorité des encres d'argent connues et de la couche d'oxyde transparent conducteur, TCO, de former par impression une couche en matériau conducteur sur le TCO de qualité suffisante.

En conséquence, il demeure un besoin pour une structure fiable, présentant des propriétés électriques satisfaisantes et pouvant notamment être obtenue avec un procédé ne présentant pas les inconvénients évoqués précédemment et en particulier qui soit simple de mise en oeuvre.

La présente invention vise précisément à répondre à ce besoin. L'invention est telle que définie dans les revendications 1 et 10. Des modes de réalisation préférés de la présente invention sont donnés dans les revendications dépendantes.

Ainsi la présente invention concerne une structure multicouche comportant un substrat photoélectrique, au moins une couche d'oxyde transparent conducteur, dénommée « TCO » et au moins une couche conductrice métallique dédiée à former une électrode caractérisée en ce que ladite structure possède en outre au moins une couche d'interface au contact de ladite couche d'oxyde transparent conducteur et de ladite couche conductrice métallique, ladite couche d'interface étant une monocouche moléculaire autoassemblée, dite SAM.

L'invention concerne une structure multicouche telle que définie précédemment dans laquelle ladite couche SAM est présente à l'interface et au contact de la couche d'oxyde transparent conducteur et du matériau métallique conducteur.

Dans le cadre de la présente invention, les inventeurs ont constaté qu'une modification chimique spécifique de la face de la couche d'oxyde transparent conducteur dédiée à être au contact avec une couche conductrice métallique, permet d'en diminuer significativement l'énergie de surface et de maîtriser alors efficacement l'étalement de l'encre métallique appliquée consécutivement sur cette face ainsi modifiée, lors de sa métallisation par impression jet d'encre.

Cette modification chimique comprend la formation d'une monocouche moléculaire autoassemblée, dite encore SAM, à savoir une couche dont l'épaisseur est d'une seule molécule. Cette molécule est immobilisée de façon ordonnée *via* une interaction chimique, notamment covalente et modifie de façon permanente les propriétés de surface de la couche TCO d'origine.

Selon un mode de réalisation non couvert par le texte des revendications, cette monocouche moléculaire autoassemblée, SAM, peut être formée à partir d'au moins un composé de formule (I) suivante :

$$R_1\text{-}R_2 \qquad \text{(I)}$$

dans laquelle :

- $R_1$ est un motif apolaire et de préférence une chaîne hydrocarbonée aliphatique, aromatique, linéaire ou ramifiée notamment d'au moins trois atomes de carbone. Par exemple, cette chaîne est une chaîne d'alcane linéaire $C_nH_{2n+1}$, où n est un nombre entier supérieur à trois et en particulier est un nombre entier variant de 3 à 34 et de préférence de 3 à 18.
- $R_2$ est un groupement apte à se lier directement en surface de la couche d'oxyde transparent conducteur et en particulier est choisi parmi les groupements COOH, CHO, $CH_2OH$, $P(R_3)_3$, $PO(OH)_2$, $NH_2$, SH ou $Si(R_3)$ avec $R_3$ représentant un atome d'halogène notamment de fluor ou de chlore, un radical éther ou thioéther comprenant de 1 à 2 atomes.

Le groupement $R_2$ contrôle le greffage sur la couche ITO et le groupement $R_1$ permet la modulation de l'énergie de surface.

Selon la présente invention, la couche SAM est formée à partir d'un silane.

Selon la présente invention, la couche SAM est formée à partir d'un silane de formule générale (II) suivante

$$R\text{-}Si\,(X)_3 \qquad \text{(II)}$$

dans laquelle

- R est une chaîne hydrocarbonée aliphatique, aromatique, linéaire ou ramifiée notamment d'au moins trois atomes de carbone,
- X est un atome d'halogène notamment de chlore ou un radical éther ou thioéther en $C_1$ à $C_2$.

A titre illustratif des précurseurs de couche SAM convenant tout particulièrement à l'invention peuvent notamment être cités les triméthoxy(propyl)silane, triéthoxy(octyl)silane et triméthoxy(octadecyl)silane, triméthoxy(isobutyl)silane, triméthoxy(2-phényl)silane.

Avantageusement l'épaisseur de la couche SAM n'excède pas 5 nm et de préférence 3 nm.

Comme il ressort des exemples ci-après, le traitement chimique avec une couche SAM permet de réduire significativement l'énergie de surface du support dédié à supporter le réseau de fils métalliques et permet ainsi d'accéder à des dépôts métalliques conducteurs de taille plus réduite sans impacter les performances de l'empilement.

L'invention concerne encore un procédé de fabrication d'une structure multicouche selon la revendication 10.

Ainsi, la présente invention concerne un procédé de fabrication d'une structure multicouche comportant un substrat photoélectrique, au moins une couche d'oxyde transparent conducteur et au moins une couche conductrice métallique 25 dédiée à former une électrode, comportant au moins les étapes successives suivantes consistant à :

a) disposer d'un substrat photoélectrique recouvert d'au moins une couche d'oxyde transparent conducteur,
b) mettre en contact au moins la face externe de ladite couche d'oxyde transparent conducteur avec au moins des molécules aptes à former une monocouche moléculaire autoassemblée, SAM, dans des conditions propices à la formation de ladite couche SAM en surface de ladite couche d'oxyde transparente, notamment par trempage de ladite face externe de ladite couche d'oxyde transparent conducteur à traiter dans un milieu liquide contenant les molécules auto- assemblables,
c) former des gouttelettes liquides d'au moins un matériau métallique conducteur et au contact de ladite couche SAM, le matériau métallique conducteur étant notamment appliqué à l'état de gouttelettes liquides d'une solution le contenant et ladite solution étant notamment déposée par impression par jet d'encre, et
d) sécher lesdites gouttelettes pour former au moins un fil métallique conducteur, ladite étape de séchage étant notamment réalisée entre 0,5 minute et 10 minutes et à une température comprise entre 120°C et 200°C.

Par ailleurs, l'invention concerne aussi un dispositif choisi parmi les cellules photovoltaïques silicium de type HET, les cellules pérovskites ou encore les cellules tandems silicium pérovskite le dispositif comportant une structure multicouche selon l'invention ou obtenue à partir d'un procédé selon l'invention.

D'autres caractéristiques, variantes et avantages de l'invention ressortiront mieux à la lecture de la description détaillée et des exemples qui vont suivre, donnés à titre illustratif et non limitatif, et à l'examen des figures annexées.

- la figure 1 illustre, de manière schématique, la méthodologie de formation d'une couche SAM selon l'invention.
- la figure 2 représente l'évolution de la taille des gouttes et de l'énergie de surface pour une couche SAM formée à partir d'un silane dit C8 à une concentration molaire de 0,005M dans le chloroforme.
- la figure 3 représente l'évolution de la taille des gouttes et de l'énergie de surface pour une couche SAM formée à partir d'un silane dit C18 à une concentration molaire de 0,005M dans le chloroforme selon l'exemple 1, et
- la figure 4 représente en coupe transversale un exemple d'empilement multicouche selon l'invention.

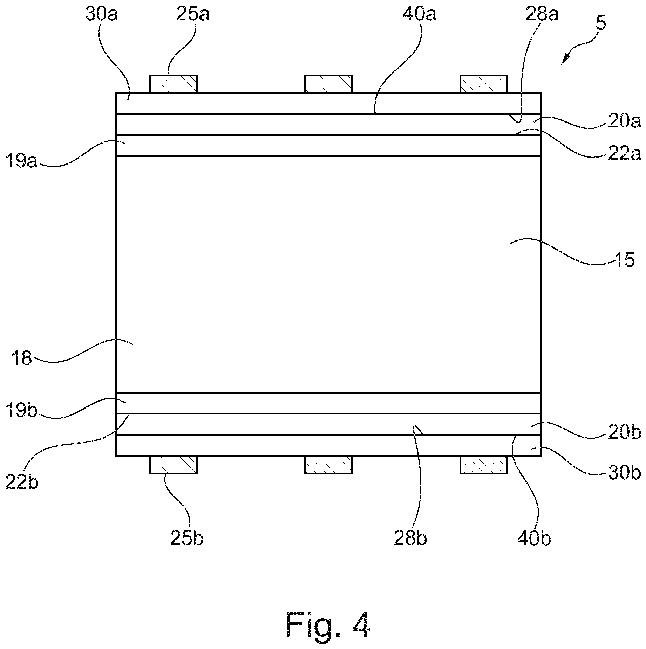

Il convient de noter que pour des raisons de clarté, les différents éléments des figures 4 sont représentés en échelle libre, leurs dimensions réelles et leurs proportions réelles n'étant pas respectées.

Dans la suite du texte, les expressions « compris entre ... et ... », « allant de ... à ... » et « variant de ... à ... » sont équivalentes et entendent signifier que les bornes sont incluses, sauf mention contraire.

## EMPILEMENT SELON L'INVENTION

La figure 4 représente une structure multicouche 5 conforme à l'invention. Cette structure multicouche comporte un substrat 15, des couches d'oxyde transparent conducteur 20a-b, des couches SAM 30a-b et des couches métallique 25a-b.

Le substrat est photoélectrique, générant un courant électrique lorsqu'il est irradié par un rayonnement lumineux.

Selon un mode de réalisation avantageux, le substrat est de nature inorganique.

Selon la variante illustrée sur la figure 4, l'empilement multicouche définit une cellule photovoltaïque à hétérojonction. Le substrat comporte un support 18 en silicium cristallin, dénommé « c-Si », recouvert sur chacune de ses faces par une couche 19a-b en silicium amorphe hydrogéné, dénommée « a-Si:H ».

Selon une autre variante, l'empilement multicouche peut définir une cellule photovoltaïque à base de matériaux de type perovskite hybride halogéné. Le substrat comporte alors une couche active semi-transparente en un matériau perovskite de formule générale $APbX_3$ où

- A est un cation ou un mélange de cations notamment choisis parmi le cation méthylammonion (MA+) ; le cation formamidium (FA+) ; $Cs^+$ et $Rb^+$,
- X est un halogène notamment choisi parmi I ; Br et Cl avec X pouvant avoir des définitions distinctes dans le matériau $APbX_3$.

Selon encore une autre variante, l'empilement multicouche définit une cellule photovoltaïque de type tandem silicium-perovskite. Par exemple, le substrat comporte alors un premier ensemble comportant un support en c-Si recouvert sur chaque face par des couches en a-Si:H. Le premier ensemble est recouvert par un deuxième ensemble multicouche comportant une couche active constituée d'un matériau de type perovskite.

Le support peut, comme illustré, se présenter sous la forme d'une plaque cette forme n'étant toutefois pas restrictive. Il peut aussi se présenter sous la forme d'un film.

Le ou les matériaux constitutifs du substrat peuvent être adaptés en fonction du dispositif électronique, par exemple une diode électroluminescente, dans lequel la structure multicouche selon l'invention est intégrée et/ou des matériaux constituant la couche d'oxyde transparent conducteur et/ou la couche métallique.

Les couches d'oxyde transparent conducteur 20a-b sont disposées sur les faces opposées du substrat. Chaque couche d'oxyde transparent conducteur est supportée par le substrat 15. Elle présente une face inférieure 22a-b en contact avec le substrat et une face supérieure 28a-b opposée.

Par ailleurs, les couches d'oxyde transparent conducteur sont disposées chacune au contact d'une couche SAM 30a-b respective. Chaque couche d'oxyde transparent conducteur est ainsi prise en sandwich entre la couche SAM respective et le substrat.

Par ailleurs, les couches SAM et/ou les couches TCO peuvent être texturées de manière à augmenter la quantité de lumière pouvant être reçue par le substrat photoélectrique.

Comme cela est illustré sur la figure 4, le contact avec le substrat s'effectue sur l'ensemble de la face inférieure. Le contact avec la couche SAM s'effectue sur la face supérieure de la couche d'oxyde transparent conducteur, définissant ainsi une surface de contact 40a-b.

La couche d'oxyde transparent conducteur peut présenter une épaisseur comprise entre 50 nm et 1000 nm, en particulier entre 100 et 500 nm.

La couche d'oxyde transparent conducteur peut être déposée sous la forme d'une couche unique, par exemple en oxyde d'Indium - Etain (ITO), en ZnO dopé Aluminium (AZO), en ZnO dopé Etain (ZTO), ZnO dopé au Gallium (GZO), ZnO dopé Indium (IZO), ZnO dopé Indium et Gallium (IGZO).

Cet oxyde peut également être déposé sous la forme de deux ou trois couches de matériaux différents, par exemple ITO/Ag/ITO, AZO/Ag/AZO, AZO/Au/AZO, AZO/Ag/ZnO, ou encore ZnO/Ag/ZnO.

De préférence, la couche d'oxyde transparent conducteur est en un matériau choisi parmi l'oxyde d'Indium dopé à l'Etain (communément dénommé ITO pour l'appellation anglaise « Indium Tin Oxide »), l'oxyde d'Indium dopé au Zinc (communément dénommé IZO pour l'appellation anglaise « Indium Zinc Oxide »), l'oxyde de Zinc, de préférence dopé, et leurs mélanges.

La monocouche moléculaire autoassemblée, SAM, est présente à l'interface et au contact de la couche d'oxyde transparent conducteur et du matériau métallique conducteur.

Avantageusement, la couche SAM est continue. Ainsi, elle est généralement en contact avec la totalité de la face supérieure de la couche d'oxyde transparent conducteur (28a-b).

La couche SAM peut être ainsi prise en sandwich entre la couche d'oxyde transparent conducteur et la couche conductrice métallique.

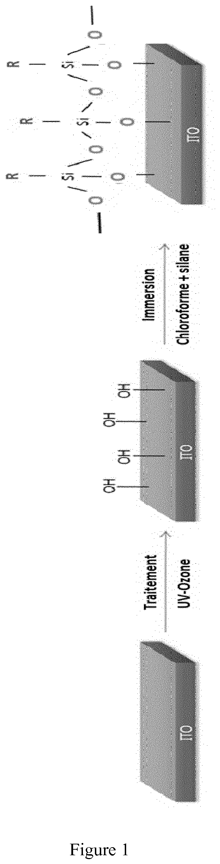

Comme illustré en figure 1, dans l'état auto-assemblé, les molécules 38 s'alignent parallèlement les unes aux autres pour former une monocouche de molécules. En particulier, les molécules sur les empilements les plus denses sont parallèles les unes vis-à-vis des autres mais déposées avec un angle d'inclinaison de tilt par rapport au substrat.

En particulier, la couche SAM peut posséder une épaisseur inférieure à 10nm, de préférence inférieure à 5nm, plus préférentiellement inférieure à 3nm. Au regard de sa faible épaisseur, elle n'impacte pas les performances électriques de l'empilement.

La présence de molécule peut être détectée par des techniques telles que l'XPS (« X-Ray Photoelectron Spectrometry ») ou le ToF SIMS (« Time of Flight Secondary Ion Mass Spectrometry »).

Selon un mode de réalisation non couvert par le texte des revendications, cette couche monomoléculaire auto-assemblée, SAM, peut être formée à partir d'au moins un composé de formule (I) suivante :

$$R_1\text{-}R_2 \qquad \text{(I)}$$

dans laquelle :

- $R_1$ est un motif apolaire et de préférence une chaîne hydrocarbonée aliphatique, aromatique, linéaire ou ramifiée notamment d'au moins 3 atomes de carbone. Par exemple, cette chaîne est une chaîne d'alcane linéaire ($C_nH_{2n+1}$), où n est supérieur ou égal à 3.
- $R_2$ est un motif apte à se lier directement en surface de la couche d'oxyde transparent conducteur et est en particulier choisi parmi les motifs thiol, disulfure, un acide dithioïque, dithiocarbamate, silane, chlorosilane, dichlorosilane, trichlorosilane, alcoxysilane, dialcoxysilane, trialcoxysilane, acide hydroxyamique, phosphate, acide phosphonique, acide carboxylique acide hydroxamique, alcool, amine, sulfate, sulfonate et sulfinate et de préférence parmi les groupements COOH, CHO, $CH_2OH$, $P(R_3)_3$, $NH_2$, SH ou $Si(R_3)_3$ avec $R_3$ représentant un atome d'halogène notamment de fluor ou de chlore, un radical éther ou thioéther comprenant de 1 à 2 atomes.

Comme énoncé précédemment, le groupement $R_2$ contrôle le greffage sur l'ITO et le groupement $R_1$ permet la modulation de l'énergie de surface.

Selon la présente invention, la couche SAM est formée à partir d'un silane.

Selon la présente invention, la couche SAM est formée à partir d'un silane de formule générale (II) suivante

$$R_1\text{-}Si\,(X)_3 \qquad \text{(II)}$$

dans laquelle

- $R_1$ une chaîne hydrocarbonée aliphatique, aromatique, linéaire ou ramifiée notamment telle que définie en formule (I) et
- X est un atome d'halogène notamment de chlore ou un radical éther ou thioéther en $C_1$ à $C_2$.

Selon un mode de réalisation non couvert par le texte des revendications, la couche SAM peut être formée à partir d'un silane de formule générale (III) suivante

$$R_1\text{-}Si\,(OX')_3 \qquad \text{(III)}$$

avec $R_1$ étant tel que défini en formule (I) ou (II) et X' étant un radical hydrocarboné linéaire ou ramifié, de préférence saturé, en $C_1$ à $C_{34}$.

A titre illustratif des silanes convenant pour la formation d'une couche SAM peuvent notamment être cités les triméthoxy(propyl)silane, triéthoxy(octyl)silane, triméthoxy(octadécyl)silane, triméthoxy(isobutyl)silane et triméthoxy(2-phényl)silane.

Comme illustré en figure 1, les molécules formant la couche SAM sont immobilisées de façon ordonnée à la couche conductrice transparente via une interaction chimique, notamment covalente, et modifient de façon permanente les propriétés de surface dudit substrat.

Avantageusement, la couche SAM possède une énergie de surface inférieure à l'énergie de surface de la couche d'oxyde transparent conducteur, TCO, et de préférence inférieure à 100 mJ/cm$^2$, de préférence inférieure à 50 mJ/cm$^2$ et en particulier inférieure à 40 mJ/cm$^2$ Cette énergie de surface peut notamment être évaluée selon la méthode décrite dans les exemples qui suivent.

En particulier, et comme illustré en exemple 1, il est constaté une diminution très importante de l'énergie de surface de la face de la couche d'oxyde transparent conducteur après sa fonctionnalisation avec la couche SAM. Cette diminution est d'au moins 50% par rapport à la valeur de l'énergie de surface constatée avant traitement selon l'invention.

Cette diminution s'avère particulièrement bénéfique lors de la mise en contact de la couche SAM avec les gouttelettes du matériau conducteur métallique qui sont déposées sur sa surface pour former le ou les dépôts conducteurs métalliques dédié(s) à former une électrode. Il est ainsi noté une diminution significative du diamètre moyen des gouttes qui évolue de la même façon que l'énergie de surface. Il s'avère ainsi possible de réduire la largeur de l'impression de l'ordre de 20% tout en conservant des propriétés électriques équivalentes.

Des exemples de métaux adaptés à la réalisation de la couche métallique sont l'argent (Ag), l'aluminium (Al), l'or (Au), le cuivre (Cu), le nickel (Ni), le platine (Pt), le tungstène (W), le titane (Ti) et le chrome (Cr) et les alliages ou les mélanges d'au moins deux de ces métaux. De préférence, le métal est choisi parmi l'argent (Ag), l'or (Au), le cuivre (Cu), et les alliages ou les mélanges d'au moins deux de ces métaux et mieux est l'argent.

Un exemple de structure multicouche adaptée à la réalisation des électrodes est une structure multicouche d'AZO et d'argent.

Selon la présente invention, la couche métallique est organisée sous la forme d'au moins un fil et de préférence sous la forme d'un réseau de fils. En particulier, ces fils sont en un métal choisi parmi l'argent (Ag), l'or (Au), le cuivre (Cu), le platine (Pt), le palladium (Pd), le nickel (Ni), le cobalt (Co), le rhodium (Rh), l'iridium (Ir), le ruthénium (Ru), et le fer (Fe), de préférence choisis parmi Ag, Au et Cu, plus préférablement choisi parmi Ag et Au.

La couche métallique, en particulier lorsqu'elle est en argent, présente une épaisseur comprise entre 50 nm et 2000 nm, de préférence entre 100 nm et 1000 nm.

En particulier, la couche conductrice métallique et la couche d'oxyde transparent conducteur ne sont pas en contact.

Par ailleurs, la structure multicouche est généralement dénuée d'une superposition de deux, ou plus, couches métalliques directement disposées au contact l'une de l'autre.

Selon un mode de réalisation préféré, la couche métallique se présente sous la forme d'au moins une ligne, et de préférence de plusieurs lignes, en argent de préférence formés par impression par jet d'encre en surface de la couche SAM.

## PROCEDE DE PREPARATION D'UN EMPILEMENT SELON L'INVENTION

L'invention concerne également un procédé de fabrication d'une structure multicouche conforme à l'invention et comportant les étapes successives suivantes consistant à :

    a) disposer d'un substrat photoélectrique recouvert d'au moins une couche d'oxyde transparent conducteur,
    b) mettre en contact au moins la face externe de ladite couche d'oxyde transparent conducteur avec au moins des molécules aptes à former une monocouche moléculaire autoassemblée, SAM, dans des conditions propices à la formation de ladite couche SAM en surface de ladite couche d'oxyde transparente,
    c) former des gouttelettes liquides d'au moins un matériau métallique conducteur et au contact de ladite couche SAM et
    d) sécher lesdites gouttelettes pour former au moins une ligne métallique conductrice.

Selon un mode réalisation préféré, l'étape b) est réalisée par trempage/immersion, de préférence par trempage de la face à traiter de la couche d'oxyde transparent conducteur avec les molécules auto-assemblables.

Cette imprégnation peut être réalisée par trempage de la face à traiter dans un milieu liquide contenant les molécules auto-assemblables et en prolongeant ce trempage suffisamment longtemps pour accroître la densité et l'homogénéité des molécules transférées sur la face devant servir de support à la couche de matériau conducteur métallique.

Cette imprégnation peut être également réalisée par pulvérisation sur la face à traiter de la couche d'oxyde transparent conducteur d'un milieu liquide contenant les molécules auto- assemblables.

Selon un mode de réalisation non couvert par le texte des revendications, ces molécules auto-assemblables peuvent être de formules générales (I) ou (III) telles que définies ci-dessus. Selon l'invention, ces molécules auto-assemblables sont de formule générale (II) telle que définie ci-dessus.

De préférence, la concentration molaire de molécules auto-assemblables dans la solution est compris 0.0005 et 0.1M et de préférence entre 0.001 et 0.01M.

Comme illustré en exemple 1, une couche SAM formée à l'issue de l'étape b) possède avantageusement une énergie de surface dont la valeur est significativement inférieure à celle possédée par la couche d'oxyde transparent conducteur d'origine. Cette diminution est particulièrement bénéfique pour former à l'issue des étapes c) et d) des lignes métalliques de taille réduite.

En d'autres termes, la couche SAM module la mouillabilité de la couche active en diminuant son hydrophilie.

Le matériau métallique conducteur est appliqué à l'état de gouttelettes liquides d'une solution le contenant.

En particulier, la solution comprend le matériau formant la couche métallique en dispersion dans un solvant. Pour le cas où le matériau formant la couche métallique est en argent, le solvant peut être un alcool ou un glycol, et de préférence est choisi parmi l'éthanediol, le propanediol, le glycérol, le butanol, l'isopropanol, l'éthanol et leurs mélanges.

De préférence, cette solution possède entre 5 et 50% en masse, de préférence entre 10 et 40% en poids en matériau conducteur métallique.

La solution est avantageusement déposée par impression par jet d'encre, notamment sous la forme de gouttes, en surface de la couche d'oxyde transparent conducteur. De préférence, la distance entre deux gouttes successives est choisie de telle sorte que les gouttes coalescent entre elles pour former une ligne continue. On parle de « coalescence » des gouttes lorsque les gouttes déposées côte à côte, en s'étalant, se réunissent du fait notamment de la tension superficielle des gouttes et éventuellement de leur mobilité sur le substrat sur lequel elles sont déposées.

La couche métallique peut être déposée en effectuant une unique ou plusieurs séquences successives d'opérations d'impression par jet d'encre et de séchage de sous-couches et surcouches.

L'impression peut notamment être réalisée à l'aide d'une Imprimante Dimatix DMP 2600.

L'opération d'impression, notamment par jet d'encre, est ensuite suivie d'une opération de séchage des gouttelettes. Cette étape de séchage est de préférence réalisé entre 0,5 minute et 10 minutes et à une température comprise entre 120 °C et 200 °C. Dans le cas où le substrat est en verre, la température de séchage de la solution peut être supérieure à 150 °C, tout en restant inférieure à 300 °C. Ainsi, le solvant est évaporé de la couche liquide et la couche métallique est formée.

Les lignes obtenues à l'issu du séchage des gouttelettes peuvent posséder une largeur variant de 20 à 100 $\mu$m et notamment de 20 à 50 $\mu$m.

Selon une autre variante de réalisation, la face à traiter de la couche d'oxyde transparent conducteur, subit préalablement à l'étape b), un traitement de surface UV-ozone.

De même, antérieurement, à l'étape a), la couche d'oxyde transparent conducteur peut avoir été formée au préalable par dépôt physique en phase vapeur (PVD en anglais) ou par dépôt chimique en phase vapeur (CVD en anglais). Ces techniques sont bien connues de l'homme du métier, qui sait choisir un substrat adapté, par exemple tel que décrit précédemment, pour réaliser un tel dépôt.

## DISPOSITIF

L'invention concerne également un dispositif comportant une structure multicouche selon l'invention ou obtenue à partir d'un procédé selon l'invention.

En particulier, ce dispositif est choisi parmi les cellules silicium de type HET, cellules pérovskites ou encore les cellules tandems silicium pérovskite.

Notamment, le dispositif peut être une cellule photovoltaïque pérovskite.

Bien entendu, l'invention n'est pas limitée aux modules spécifiques décrits ci-dessus, et d'autres applications de la structure multicouche selon l'invention peuvent être envisagées.

L'invention va maintenant être décrite au moyen des exemples suivants, donnés à titre illustratif et non limitatif de l'invention.

## Méthodes et matériels

. L'empilement est le suivant: Substrat HET / couche d'oxyde transparent conducteur (TCO) : oxyde d'indium dopé à l'étain (ITO) d'épaisseur de 300 nm / couche d'argent.

Sauf mention contraire, l'ensemble des impressions a été réalisée avec une encre argent de DuPont (Référence PE410) à 40% en masse d'argent (diamètre des particules < 150 nm) dispersé dans du TGME (monométhyléther de triéthylène glycol).

L'énergie de surface est évaluée par mesure de l'angle de contact des 3 solvants testés (eau, éthylène glycol et diiodométhane). L'énergie de surface du substrat est ensuite appréciée avec la convention du modèle d'Owens Wendt

$$W_{\text{SL}} = (1+\cos\theta)\gamma_{\text{L}} \quad = \quad 2\sqrt{\gamma_s^d \gamma_L^d} \quad + \quad 2\sqrt{\gamma_s^p \gamma_L^p}$$

modèle Owens-Wendt

énergie d'adhésion solide-liquide | composantes dispersive/apolaire | composantes non-dispersive/polaire

### Exemple 1

Trois dérivés silanes différents ont été utilisés et comparés :

le trimethoxy(propyl)silane (ci -après noté C3)
le triethoxy(octyl)silane (C8)
le trimethoxy(octadecyl)silane (C18).

Pour chacun des silanes, trois concentrations différentes ont été évaluées (0,001 mol/L, 0,005 mol/l et 0,01 mol/L dans le chloroforme anhydre) avec des temps d'immersion allant d'une heure à cinq heures.

Sans traitement selon l'invention, l'énergie de surface est supérieure à 70 mJ/m$^2$

Le Tableau 1 regroupe les énergies de surface obtenues pour les trois silanes après 4h d'immersion aux différentes concentrations.

Tableau 1

|  | 0,001 mol/L | 0,005 mol/L | 0,01 mol/L |
|---|---|---|---|
| **C3** | 44,3 | 39,2 | 42,7 |
| **C8** | 34,2 | 23,9 | 26,8 |
| **C18** | 31,8 | 26,6 | 22,3 |

Comme le montre l'ensemble de ces données, on observe une diminution très importante de l'énergie de surface après traitement. Au minimum, une énergie de surface proche de 22 mJ/m$^2$ est obtenue, soit une valeur très proche de l'énergie de surface du téflon, d'environ 21 mJ/m$^2$.

Il peut être noté que les silanes C8 et C18 permettant d'atteindre les énergies de surface les plus faibles.

Des impressions d'encre argent ont ensuite été réalisées, selon le protocole décrit ci-dessus, sur des ITO préalablement traités avec ces deux silanes. Après dépôt, la couche liquide de solution d'argent est séchée à 140 °C pendant 1 minute pour sécher l'encre et figer la taille des lignes.

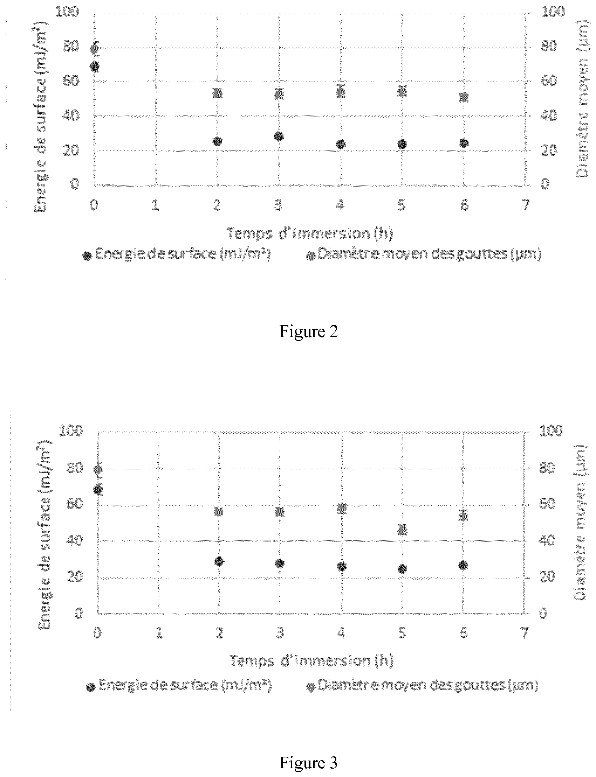

Les résultats obtenus sont présentés sur les Figures 2 et 3.

Il est ainsi constaté que le diamètre moyen des gouttes évolue de la même façon que l'énergie de surface. Ces résultats confirment donc l'influence significative de la couche SAM sur l'étalement de l'encre. Dans cette configuration, il s'avère possible de réduire la largeur de l'impression de l'ordre de 20% tout en conservant des propriétés électriques équivalentes.

### EXEMPLE 2

Les essais réalisés en exemple 1 ont été reproduits avec d'autres silanes (temps d'immersion 4h et produits SunChemical 5730 & 5603 ; PV Nanocell 130 à titre d'encres commerciales) Le tableau 2 rend compte de la nature chimique des silanes considérés et de la largeur des dépôts obtenus par microscopie optique.

Tableau 2

| Nature du silane et sa concentration | Nature de l'encre Largeur en $\mu$m du dépôt | | |
|---|---|---|---|
|  | **5730** | **5603** | **130EG1** |
| **C8 - [0,01]** | 40,94 | 42,78 | 31,13 |
| **C18 - [0,01]** | 39,23 | 37,02 | 29,78 |
| **Isobutyl(trimethoxy) silane- [0,01]** | 104,13 |  | 51,87 |
| **Trimethoxy(2phenyl) silane- [0,005]** | 109,26 | 118,56 | - |

(suite)

| Nature du silane et sa concentration | Nature de l'encre Largeur en $\mu$m du dépôt | | |
|---|---|---|---|
| | **5730** | **5603** | **130EG1** |
| **Trimethoxy(2phenyl) silane- [0,01]** | 103,04 | 95,54 | - |
| **TEMOIN Sans traitement** | 144,29 | 162,32 | 145,9 |

Ces résultats confirment qu'un empilement conforme à l'invention permet de réduire très significativement la largeur des impressions. Dans certains cas, l'étalement est divisé par un facteur 4 ce qui est particulièrement avantageux pour réaliser des lignes les plus fines possibles.

**Revendications**

1. Structure multicouche (5) comportant un substrat (15) photoélectrique, au moins une couche d'oxyde transparent conducteur (20a-b) et au moins une couche conductrice métallique (25a-b) dédiée à former une électrode, ladite structure possédant en outre au moins une couche d'interface (30a-b) au contact de ladite couche d'oxyde transparent conducteur et de ladite couche conductrice métallique, ladite couche d'interface étant une monocouche moléculaire autoassemblée, dite SAM, avec ladite couche SAM présente à l'interface et au contact de la couche d'oxyde transparent conducteur et du matériau métallique conducteur, étant en contact avec la totalité de la face supérieure de la couche d'oxyde transparent conducteur (28a-b) **caractérisée en ce que** ladite couche SAM est formée à partir d'un silane de formule générale (II) suivante

$$R\text{-}Si\,(X)_3 \qquad (II)$$

dans laquelle

- R est une chaîne hydrocarbonée aliphatique, aromatique, linéaire ou ramifiée notamment d'au moins trois atomes de carbone,
- X est un atome d'halogène notamment de chlore ou un radical éther ou thioéther en C1 à C2, et

ledit matériau conducteur métallique étant déposé sous la forme d'au moins un fil.

2. Structure multicouche selon la revendication précédente, dans laquelle ledit silane est choisi parmi les triméthoxy(propyl)silane, triéthoxy(octyl)silane,triméthoxy(octadecyl)silane, triméthoxy(isobutyl)silane et triméthoxy(2-phényl)silane.

3. Structure multicouche selon l'une quelconque des revendications précédentes dans laquelle ladite couche SAM possède une énergie de surface inférieure à l'énergie de surface de la couche d'oxyde transparent conducteur, TCO et de préférence inférieure à 100 mJ/cm$^2$, de préférence inférieure à 50 mJ/cm$^2$, en particulier inférieure à 40 mJ/cm$^2$.

4. Structure multicouche selon l'une quelconque des revendications précédentes dans laquelle ladite couche SAM possède une épaisseur inférieure à 5 nm et de préférence inférieure à 3 nm.

5. Structure multicouche selon l'une quelconque des revendications précédentes, dans laquelle le substrat (15) comporte un support (18) en silicium cristallin, dénommé « c-Si », recouvert sur chacune de ses faces par une couche (19a-b) en silicium amorphe hydrogénée, dénommée « a-Si:H ».

6. Structure multicouche selon l'une quelconque des revendications précédentes, dans laquelle la couche d'oxyde transparent conducteur est en un matériau choisi parmi l'oxyde d'Indium dopé à l'Etain, l'oxyde d'Indium dopé au Zinc, l'oxyde de Zinc, de préférence dopé, et leurs mélanges.

7. Structure multicouche selon l'une quelconque des revendications précédentes, dans laquelle le matériau conducteur métallique est déposé sous la forme d'un réseau de fils métalliques.

**8.** Structure multicouche selon l'une quelconque des revendications précédentes, dans laquelle le matériau conducteur métallique est choisi parmi l'argent (Ag), l'or (Au), le cuivre (Cu), et les alliages ou les mélanges d'au moins deux de ces métaux et de préférence est l'argent.

**9.** Structure multicouche selon l'une quelconque des revendications précédentes, dans laquelle le matériau conducteur métallique est présent sous la forme d'au moins une ligne et de préférence plusieurs lignes en argent formé par impression par jet d'encre en surface de la couche SAM.

**10.** Procédé de fabrication d'une structure multicouche (5) selon l'une quelconque des revendications 1 à 9, comportant un substrat (15) photoélectrique, au moins une couche d'oxyde transparent conducteur, (20a-b) et au moins une couche conductrice métallique (25a-b) dédiée à former une électrode comportant les étapes successives suivantes consistant à :

a) disposer d'un substrat photoélectrique recouvert d'au moins une couche d'oxyde transparent conducteur,
b) mettre en contact au moins la face externe de ladite couche d'oxyde transparent conducteur avec au moins des molécules aptes à former une monocouche moléculaire autoassemblée, SAM, en surface de ladite couche d'oxyde transparente dans des conditions propices à la formation de ladite couche SAM, notamment par trempage de ladite face externe de ladite couche d'oxyde transparent conducteur à traiter dans un milieu liquide contenant les molécules auto- assemblables.
c) former des gouttelettes liquides d'au moins un matériau métallique conducteur au contact de ladite couche SAM, le matériau métallique conducteur étant notamment appliqué à l'état de gouttelettes liquides d'une solution le contenant et ladite solution étant notamment déposée par impression par jet d'encre, et
d) sécher lesdites gouttelettes pour former au moins un fil métallique conducteur, ladite étape de séchage étant notamment réalisée entre 0,5 minute et 10 minutes et à une température comprise entre 120°C et 200°C.

**11.** Dispositif comportant une structure multicouche selon l'une quelconque des revendications 1 à 9 ou obtenue à partir d'un procédé selon la revendication 10.

**12.** Dispositif selon la revendication précédente choisi parmi les cellules silicium de type HET, cellules pérovskites ou encore les cellules tandems silicium pérovskite.


**Patentansprüche**

**1.** Mehrlagiger Aufbau (5), der ein photoelektrisches Substrat (15), mindestens eine leitfähige transparente Oxidschicht (20a-b) und mindestens eine leitfähige Metallschicht (25a-b) aufweist, die dafür bestimmt ist, eine Elektrode zu bilden, wobei der Aufbau ferner mindestens eine Grenzflächenschicht (30a-b) im Kontakt mit der leitfähigen transparenten Oxidschicht und der leitfähigen Metallschicht besitzt, wobei die Grenzflächenschicht eine als SAM bezeichnete selbstassemblierte molekulare Monolage ist, wobei die SAM-Schicht an der Grenze zu und im Kontakt mit der leitfähigen transparenten Oxidschicht und dem leitfähigen Metallwerkstoff die gesamte Oberseite der leitfähigen transparenten Oxidschicht (28a-b) berührt, **dadurch gekennzeichnet, dass** die SAM-Schicht aus einem Silan mit der folgenden allgemeinen Formel (II)

$$R\text{-}Si\,(X)_3 \qquad (II)$$

gebildet ist, worin

- R eine unverzweigte oder verzweigte aliphatische, aromatische Kohlenwasserstoffkette mit insbesondere mindestens drei Kohlenstoffatomen ist,
- X ein Halogenatom, insbesondere Chloratom, oder ein Ether- oder Thioetherrest mit C1 bis C2 ist, und

wobei der leitfähige Metallwerkstoff in Form von mindestens einem Draht aufgebracht ist.

**2.** Mehrlagiger Aufbau nach dem vorhergehenden Anspruch, wobei das Silan aus Trimethoxy(propyl)silan, Triethoxy(octyl)silan, Trimethoxy(octadecyl)silan, Trimethoxy(isobutyl)silan und Trimethoxy(2-phenyl)silan ausgewählt ist.

**3.** Mehrlagiger Aufbau nach einem der vorhergehenden Ansprüche, wobei die SAM-Schicht eine Oberflächenenergie von unter der Oberflächenenergie der leitfähigen transparenten Oxidschicht, TCO, und vorzugsweise unter 100 mJ/cm2, vorzugsweise unter 50 mJ/ cm2, insbesondere unter 40 mJ/cm2 aufweist.

4. Mehrlagiger Aufbau nach einem der vorhergehenden Ansprüche, wobei die SAM-Schicht eine Dicke unter 5 nm und vorzugsweise unter 3 nm aufweist.

5. Mehrlagiger Aufbau nach einem der vorhergehenden Ansprüche, wobei das Substrat (15) einen Träger (18) aus als "c-Si" bezeichnetem kristallinem Silizium aufweist, der auf jeder seiner Flächen mit einer Schicht (19a-b) aus als "a-Si:H" bezeichnetem hydriertem amorphem Silicium bedeckt ist.

6. Mehrlagiger Aufbau nach einem der vorhergehenden Ansprüche, wobei die leitfähige transparente Oxidschicht aus einem Werkstoff gefertigt ist, der aus zinndotiertem Indiumoxid, zinkdotiertem Indiumoxid, Zinkoxid, vorzugsweise dotiert, und ihren Mischungen ausgewählt ist.

7. Mehrlagiger Aufbau nach einem der vorhergehenden Ansprüche, wobei der leitfähige Metallwerkstoff in Form von einem Netz aus Metalldrähten aufgebracht ist.

8. Mehrlagiger Aufbau nach einem der vorhergehenden Ansprüche, wobei der leitfähige Metallwerkstoff aus Silber (Ag), Gold (Au), Kupfer (Cu) und Legierungen oder Mischungen aus mindestens zwei von diesen Metallen ausgewählt ist und vorzugsweise Silber ist.

9. Mehrlagiger Aufbau nach einem der vorhergehenden Ansprüche, wobei der leitfähige Metallwerkstoff in Form von mindestens einer Linie und vorzugsweise mehreren Linien aus Silber vorliegt, die auf der Oberfläche der SAM-Schicht mittels Tintenstrahldruck gebildet ist bzw. sind.

10. Verfahren zur Herstellung eines mehrlagigen Aufbaus (5) nach einem der Ansprüche 1 bis 9, der ein photoelektrisches Substrat (15), mindestens eine leitfähige transparente Oxidschicht (20a-b) und mindestens eine leitfähige Metallschicht (25a-b) aufweist, die dafür bestimmt ist, eine Elektrode zu bilden, das folgende aufeinanderfolgenden Schritte umfasst, die aus Folgendem bestehen:

   a) Anordnen eines photoelektrischen Substrats, das mit mindestens einer leitfähigen transparenten Oxidschicht bedeckt ist,
   b) Inkontaktbringen von mindestens der Außenseite der leitfähigen transparenten Oxidschicht mit zumindest Molekülen, die in der Lage sind, eine selbstassemblierte molekulare Monolage, SAM, an der Oberfläche der leitfähigen transparenten Oxidschicht unter für die Bildung der SAM-Schicht günstigen Bedingungen zu bilden, insbesondere durch Eintauchen der Außenseite der zu behandelnden leitfähigen transparenten Oxidschicht in ein flüssiges Medium, das die zur Selbstassemblierung fähigen Moleküle enthält,
   c) Bilden von Flüssigkeitströpfchen aus mindestens einem leitfähigen Metallwerkstoff im Kontakt mit der SAM-Schicht, wobei der leitfähige Metallwerkstoff insbesondere im Zustand von Flüssigkeitströpfchen aus einer Lösung aufgetragen wird, die ihn enthält, und die Lösung insbesondere durch Tintenstrahldruck aufgebracht wird, und
   d) Trocknen der Tröpfchen zum Bilden von mindestens einem leitfähigen Metalldraht, wobei der Schritt des Trocknens insbesondere zwischen 0,5 Minute und 10 Minuten und bei einer Temperatur zwischen 120°C und 200°C durchgeführt wird.

11. Vorrichtung, die einen mehrlagigen Aufbau nach einem der Ansprüche 1 bis 9 oder einen mehrlagigen Aufbau aufweist, der mit einem Verfahren nach Anspruch 10 erhalten wird.

12. Vorrichtung nach dem vorhergehenden Anspruch, die aus Heteroübergangs-Siliziumzellen, Perowskitzellen oder auch Silizium-Perowskit-Tandemzellen ausgewählt ist.

**Claims**

1. Multilayer structure (5) comprising a photoelectric substrate (15), at least one transparent conductive oxide layer (20a-b) and at least one conductive metal layer (25a-b) dedicated to forming an electrode, said structure also having at least one interface layer (30a-b) in contact with said transparent conductive oxide layer and said conductive metal layer, said interface layer being a self-assembled molecular monolayer, known as SAM, with said SAM layer present at the interface and in contact with the transparent conductive oxide layer and the conductive metal layer, being in contact with the whole of the upper face of the transparent conductive oxide layer (28a-b), **characterized in that** said SAM layer is formed from a silane of general formula (II) below:

$$R-Si(X)_3 \qquad (II)$$

in which:

- R is an aliphatic, aromatic, linear or branched hydrocarbon chain in particular having at least three carbon atoms,
- X is a halogen atom, in particular chlorine, or a C1 to C2 ether or thioether radical, and

said conductive metal material being deposited in the form of at least one wire.

2. Multilayer structure according to the preceding claim, in which said silane is chosen from trimethoxy(propyl)silane, triethoxy(octyl)silane, trimethoxy(octadecyl)silane, trimethoxy(isobutyl)silane and trimethoxy(2-phenyl)silane.

3. Multilayer structure according to either one of the preceding claims, in which said SAM layer has a surface energy lower than the surface energy of the transparent conductive oxide, TCO, layer and preferably of less than 100 mJ/cm$^2$, preferably less than 50 mJ/cm$^2$, in particular less than 40 mJ/cm$^2$.

4. Multilayer structure according to any one of the preceding claims, in which said SAM layer has a thickness of less than 5 nm and preferably of less than 3 nm.

5. Multilayer structure according to any one of the preceding claims, in which the substrate (15) comprises a support (18) made of crystalline silicon, referred to as "c-Si", covered on each of its faces by a layer (19a-b) of hydrogenated amorphous silicon, referred to as "a-Si:H".

6. Multilayer structure according to any one of the preceding claims, in which the transparent conductive oxide layer is made of a material chosen from tin-doped indium oxide, zinc-doped indium oxide, zinc oxide, which is preferably doped, and mixtures thereof.

7. Multilayer structure according to any one of the preceding claims, in which the conductive metal material is deposited in the form of an array of metal wires.

8. Multilayer structure according to any one of the preceding claims, in which the conductive metal material is chosen from silver (Ag), gold (Au), copper (Cu), and alloys or mixtures of at least two of these metals, and preferably is silver.

9. Multilayer structure according to any one of the preceding claims, in which the conductive metal material is present in the form of at least one line and preferably several lines of silver formed by inkjet printing on the surface of the SAM layer.

10. Process for manufacturing a multilayer structure (5) according to any one of Claims 1 to 9, comprising a photoelectric substrate (15), at least one transparent conductive oxide layer (20a-b) and at least one conductive metal layer (25a-b) dedicated to forming an electrode, comprising the following successive steps consisting in:

a) providing a photoelectric substrate covered with at least one transparent conductive oxide layer,
b) bringing at least the outer face of said transparent conductive oxide layer into contact with at least molecules capable of forming a self-assembled molecular monolayer, SAM, on the surface of said transparent oxide layer, under conditions conducive to the formation of said SAM layer, in particular by dipping said outer face of said transparent conductive oxide layer to be treated into a liquid medium containing the self-assembling molecules,
c) forming liquid droplets of at least one conductive metal material in contact with said SAM layer, the conductive metal material in particular being applied in the form of liquid droplets from a solution containing it and said solution in particular being deposited by inkjet printing, and
d) drying said droplets to form at least one conductive metal wire, said drying step in particular being carried out between 0.5 minute and 10 minutes and at a temperature between 120°C and 200°C.

11. Device comprising a multilayer structure according to any one of Claims 1 to 9 or obtained from a process according to Claim 10.

12. Device according to the preceding claim, chosen from HET silicon cells, perovskite cells or else silicon-perovskite tandem cells.

Figure 1

Figure 2

Figure 3

Fig. 4

## RÉFÉRENCES CITÉES DANS LA DESCRIPTION

**Documents brevets cités dans la description**

- US 2015171241 A1
- US 2012111401 A1

**Littérature non-brevet citée dans la description**

- **YIP HIP-LAP et al.** Self-assembled monolayer modified ZnO/metal bilayer cathodes for polymer/fullerene bulk-heterojunction solar cells. *Appl. Physics Letters,* 16 Mai 2008, vol. 92 (19), ISSN 0003-6951, 193313-193313